# EUROPEAN PATENT APPLICATION

(11) **EP 1 137 331 A2**
(43) Date of publication of application: **26.09.2001**
(21) Application number: 01101696.1
(22) Date of filing: 30.01.2001
(51) Int. Cl.: H05K 3/38, H01L 23/498

(54) **Copper on polymer component having improved adhesion**

(30) Priority: 21.03.2000 US 532147
(71) Applicant: GA-TEK, Inc. (doing business as Gould Electronics Inc.), Eastlake, Ohio 44095-4001 (US)
(72) Inventor: Bergstresser, Tad R., Shaker Heights, Ohio 44122 (US); Hilburn, Rocky L., Phoenix, Arizona 85048 (US); Sallo, James S., Palm Desert, California 92260 (US)
(74) Representative: Becker, Thomas, Dr., Dipl.-Ing.

(57) **Abstract**

A component for use in manufacturing electronic interconnection devices, comprised of a polyimide film having a thickness of between about 12 µm and about 125 µm. A chromium tiecoat on a surface of the polyimide film, the chromium tiecoat having a thickness of between about 300 Å and about 350 Å and a copper layer on the tiecoat, the copper layer having a thickness between about 300 Å and about 70 µm.

## Description

### Field of the Invention

The present invention relates generally to electronic devices, and more specifically, to components employed in the manufacturing of high-density electronic interconnection devices.

### Background of the Invention

In recent years, metallized polymer films have become increasingly used in forming printed circuits for flexible or high-density electronic interconnection applications because of their superior electrical, thermal and chemical properties. The process of forming a printed circuit on a metallized polymer film includes one or more etching steps in which the undesired or unwanted metal, typically copper, is removed by etching the metal to leave a distinct pattern of conductive lines and elements on the surface of the polymer.

An important property of any metallized polymer film used in forming printed circuits is the adhesion of the metal to the polymer film. From a practical point of view, perhaps a more important characteristic of a metallized polymer film is the adhesion between the metal and polymer after processing. In this respect, during the processing steps to form printed circuits, the metallized polymer film is exposed to severe thermal and chemical conditions. For example, the metallized polymer film can be exposed to 1) elevated temperatures and humidity, 2) highly acidic or basic aqueous solutions, 3) highly aggressive neutral aqueous solutions and 4) organic cleaning solvents. Any one of these environments has the potential of reducing adhesion, resulting in process yield losses or finished product reliability issues.

One type of metallized polymer film widely used in flexible or high density electronic interconnection applications is copper-on-polyimide. However, some types of copper-on-polyimide components exhibit partial and complete adhesion loss after exposure to elevated temperatures and/or humidity. In this respect, polyimide undergoes thermal, thermoxidative and moisture induced degradation at elevated temperatures and/or humidity. Copper diffusion also promotes adhesion loss at elevated temperatures.

One particular process that significantly degrades adhesion between copper and polyimide is an electroless gold plating process. This process is conventionally used in forming multi-layer, high performance circuits. In this respect, circuit lines (or portions thereof) for use in high performance circuits are typically gold plated to provide better resistance to corrosion or wear, or to provide a better bonding surface. An electroless gold plating process involves exposing the copper-on-polyimide component to a combination of high pH, high cyanide and a reducing agent, such as might be found in an electroless gold cyanide bath. For conventional copper-on-polyimide components, such exposure typically results in the copper totally separating from the polyimide substrate. With the need for gold plating connections for high performance, electronic interconnection devices, it is desirable to have a copper-on-polyimide component that resists separation when exposed to electroless gold processing baths or other circuit manufacturing processes.

The present invention provides a copper-on-polyimide component that is less susceptible to de-lamination of the copper and polyimide film than copper-on-polyimide components known heretofore, and a method of forming same.

### Summary of the Invention

In accordance with a preferred embodiment of the present invention, there is provided a component for use in manufacturing printed circuits comprised of a Upilex®-SGA polyimide film having a thickness of between about 12 µm and about 125 µm. A chromium tiecoat is provided on a surface of the polyimide film. The chromium tiecoat has thickness of between about 300 Å and about 350 Å. A copper layer is provided on the tiecoat. This copper layer has a thickness greater than about 300 Å.

In accordance with another aspect of the present invention, there is provided a component for use in manufacturing printed circuits comprised of a polyimide film having a thickness of between about 12 µm and about 125 µm. A tiecoat is provided on a surface of a polyimide film. The tiecoat has a thickness of between 250 Å and 500 Å and is a metal selected from the group consisting of chromium, nickel, palladium, titanium, vanadium, aluminum, iron, chromium-based alloys and nickel-based alloys. A copper layer is provided on the tiecoat. The copper layer has a thickness between 300 Å and 70 µm.

In accordance with another aspect of the present invention, there is provided a method of forming a copper-on-polyimide component comprising the steps of: a) pre-treating by a plasma process, a surface of a polyimide film having a thickness between about 12 µm and about 125 µm; b) applying by a vacuum deposition process, a first metal as a tiecoat onto the surface of the polyimide film, the first metal selected from the group consisting of chromium, nickel, palladium, titanium, aluminum, iron, chromium-based alloys and nickel-based alloys, the tiecoat having a thickness between 250 Å and 500 Å; c) applying by a vacuum deposition process, a seedcoat of copper onto the first metal, the seedcoat having a thickness between about 300 Å and about 5,000 Å; and d) electroplating copper onto the seedcoat, wherein the copper on the component has a thickness between about 300 Å and about 70 µm.

It is an object of the present invention to provide a copper-on-polyimide component that resists de-lamination when exposed to processing conditions during a circuit manufacturing process, and especially during surface treatments and electroless gold processes.

It is another object of the present invention to provide a copper-on-polyimide component as described above that resists de-lamination when exposed to an electroless gold plating solution.

Another object of the present invention is to provide a component as described above wherein the component is comprised of copper on polyimide.

A still further object of the present invention is to provide a method of forming the component described above.

These and other objects will become apparent from the following description of a preferred embodiment taken together with the accompanying drawings and the appended claims.

### Brief Description of the Drawings

The invention may take physical form in certain parts and arrangement of parts, a preferred embodiment of which will be described in detail in the specification and illustrated in the accompanying drawings which form a part hereof, and wherein:
FIG. 1 is a schematic cross-sectional view of a component, illustrating a preferred embodiment of the present invention;
FIG. 2 is a plan view of a test circuit pattern used for testing the adhesion of copper to polyimide;
FIG. 3 is a chart showing the maximum width of copper trace lines on several test components that lifted from their respective polyimide substrate when immersed in an electroless gold bath for a period of time sufficient to deposit 64.0 micro inches of gold on the copper trace lines;
FIG. 4 is a chart showing the maximum width of copper trace lines on several test components that lifted from their respective polyimide substrate when immersed in an electroless gold bath for a period of time sufficient to deposit 37.4 micro inches of gold on the copper trace lines;
FIG. 5 is a chart showing the maximum width of copper trace lines on several test components that lifted from their respective polyimide substrate when immersed in an electroless gold bath for a period of time sufficient to deposit 30.3 micro inches of gold on the copper trace lines;
FIG. 6 is a chart showing the maximum width of copper trace lines on several test components that lifted from their respective polyimide substrate when immersed in an electroless gold bath for a period of time sufficient to deposit 16.0 micro inches of gold on the copper trace lines;
FIG. 7 is a cross-sectional view of a 3 mil copper trace line from the test pattern shown in FIG. 2, schematically illustrating how the 3 mil trace line separates from its polyimide substrate when immersed for a period of time in an electroless gold bath; and
FIG. 8 is a cross-sectional view of a 5 mil copper trace line from the test pattern shown in FIG. 2, schematically illustrating how a portion of the 5 mil trace line remains adhered to its polyimide substrate when immersed in the same electroless gold bath for the same period of time.

### Detailed Description of Preferred Embodiment

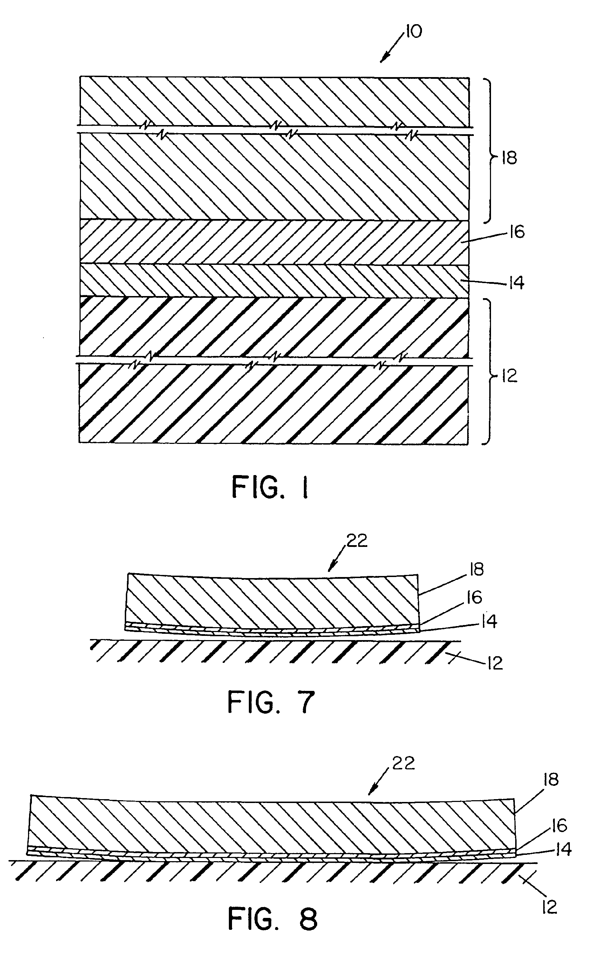

Referring to the drawing wherein the showing is for the purpose of illustrating a preferred embodiment of the invention only and not for the purpose of limiting same, a component 10 in accordance with the present invention is shown. FIG. 1 schematically illustrates an adhesiveless, copper-on-polyimide component 10 that resists de-lamination when exposed to circuit manufacturing processes and more particular when exposed to an electroless gold plating solution. Broadly stated, component 10 is comprised of a polymer film 12 having a metal tiecoat 14 thereon. A seedcoat or layer 16 of copper is disposed over tiecoat 14 and an outer layer 18 of copper is applied over seedcoat 16. As used herein the term "copper" refers to essentially pure copper, as well as copper alloys.

The present invention shall be described with respect to a component 10, wherein polymer film 12 is a polyimide and tiecoat 14 is formed of chromium. Copper-on-polyimide components having chromium tiecoats are conventionally known. However, conventionally known copper-on-polyimide components do not perform well when exposed to electroless gold plating solutions. These solutions typically include a combination of high pH, high cyanide and a reducing agent. Conventional copper-on-polyimide components tend to de-laminate when exposed to such solutions.

Referring now to the present invention, in accordance with one aspect of the present invention, polymer film 12 is preferably formed from polyimide. Polymer film 12 is preferably formed of Kapton®-E polyimide (Kapton® is a registered trademark of E. I. DuPont Nemours & Co.), and more preferably Upilex®-SGA (Upilex® is a registered trademark of Ube Industries, Ltd.). These polyimide films have the following physical properties.

**TABLE I**

| **Physical Properties of Polyimide Substrates** | | |
|---|---|---|
| **Material Designation** | **Kapton®-E** | **Upilex®-SGA** |
| **Mechanical Properties (1 mil)** | | |
| Tensile Strength, ksi, @ 25°C | 45 | 57 |
| Tensile Modulus, ksi, @ 25°C | 700 | 1280 |
| Elongation, %, @ 25°C | 55 | 30 |

| **Electrical Properties (1 mil)** | | |
|---|---|---|
| Dielectric Constant, @ 1 kHz | 3.2 | 3.5 |
| Dissipation Factor, @ 1 kHz | 0.0015 | 0.0013 |
| Dielectric Strength, V/mil | 7200 | 6800 |

| **Chemical Properties** | | |
|---|---|---|
| Water Absorption, 24 hrs. 23°C, % | 1.8 | 1.2 |
| Chemical Etch (Hot KOH) | Yes | No |

Polymer film 12 preferably has a thickness between about 12 µm and about 125 µm. In accordance with the present invention, the surface of polymer film 12 is pre-treated to clean and chemically modify the polymeric surface. In accordance with the present invention, polymer film 12 is treated, preferably plasma treated in an oxygen containing environment.

Following the pre-treatment, metal tiecoat 14 is applied to the clean surface of polymer film 12. In a preferred embodiment, tiecoat 14 is comprised of chromium. The chromium tiecoat is applied by a vacuum deposition process such as sputtering, e-beam deposition or thermal evaporation. While a chromium tiecoat 14 shall hereinafter be described, it is believed that a tiecoat 14 formed of the following metals would also find advantageous application with the present invention: nickel, palladium, titanium, tantalum, aluminum, iron, vanadium, chromium-based alloys and nickel-based alloys.

In accordance with one aspect of the present invention, the thickness of tiecoat 14 is greater than 170 Å. Preferably, the thickness of tiecoat 14 is between 170 Å and 500 Å, and more preferably between about 300 Å and about 350 Å.

Copper seedcoat 16 is applied to tiecoat 14. Seedcoat 16 provides electrical conductivity to facilitate electrodeposition of copper. Seedcoat 16 may be applied by a vacuum deposition process such as sputtering, e-beam deposition or thermal evaporation, but in a preferred embodiment of the invention is applied using a sputter deposition process. Copper seedcoat 16 is formed of copper or a copper alloy and has a thickness of between about 300 Å and about 5,000 Å, and preferably between about 1,500 Å and about 3,000 Å, and more preferably between about 2,000 Å and about 2,500 Å.

Copper layer 18 may be applied to seedcoat 16 by a vacuum metallization process such as sputtering, e-beam deposition or thermal evaporation. Copper layer 18 may also be applied by electrodeposition or by an electroless plating process. In a preferred embodiment, copper layer 18 is formed of copper or a copper alloy and is applied by a high-speed electroplating process such as that disclosed in U.S. Patent No. 5,685,970 to Ameen et al., the disclosure of which is expressly incorporated herein by reference. The total copper thickness on component 10 (i.e., seedcoat 16 and copper layer 18) is preferably between about 300 Å and about 70 µm.

To test the adhesion of copper to polyimide, tests are performed on several components. Each component includes a polymeric film 12, a tiecoat 14, a seed layer 16 and a copper layer 18. Each of the components is formed such that the thickness of each seed layer 16 is the same and the thickness of each copper layer 18 is the same. Polymeric film 12 is a polyimide, and is either Upilex®-SGA, Kapton®-E or Apical®-HP (Apical® is a registered trademark of Kaneka).

Apical®-HP has the following physical properties.

**TABLE II**

| **Physical Properties of a Polyimide Substrate** | |
|---|---|
| **Material Designation** | **Apical®-HP** |
| **Mechanical Properties (1 mil)** | |
| Tensile Strength, ksi, @ 25°C | 40.6 |
| Tensile Modulus, ksi, @ 25°C | 800 |
| Elongation, %, @ 25°C | 40 |

| **Electrical Properties (1 mil)** | |
|---|---|
| Dielectric Constant, @ 1 kHz | 3.1 |
| Dissipation Factor, @ 1 kHz | -- |
| Dielectric Strength, V/mil | -- |

| **Chemical Properties** | |
|---|---|
| Water Absorption, 24 hrs. 23°C, % | 1.2 |
| Chemical Etch (Hot KOH) | Yes |

Tiecoat 14 for each component is chromium, but the thickness of tiecoat 14 is different for some of the components.

The following components are tested.

| COMPONENT No. 1 | | |
|---|---|---|
| | MATERIAL | THICKNESS |
| Polymer film 12 | Polyimide (Upilex®-SGA) | 50 µm |
| Tiecoat 14 | Chromium | ∼85 Å |
| Seed layer 16 | Copper | ∼2000 Å |
| Layer 18 | Copper | ∼18 µm |

| COMPONENT No. 2 | | |
|---|---|---|
| | MATERIAL | THICKNESS |
| Polymer film 12 | Polyimide (Upilex®-SGA) | 50 µm |
| Tiecoat 14 | Chromium | ∼ 340 Å |
| Seed layer 16 | Copper | ∼ 2000 Å |
| Layer 18 | Copper | ∼ 18 µm |

| COMPONENT No. 3 | | |
|---|---|---|
| | MATERIAL | THICKNESS |
| Polymer film 12 | Polyimide (Kapton®-E) | 50 µm |
| Tiecoat 14 | Chromium | ∼ 160 Å |
| Seed layer 16 | Copper | ∼2000 Å |
| Layer 18 | Copper | ∼18 µm |

| COMPONENT No. 4 | | |
|---|---|---|
| | MATERIAL | THICKNESS |
| Polymer film 12 | Polyimide (Kapton®-E) | 50 µm |
| Tiecoat 14 | Chromium | ∼ 165 Å |
| Seed layer 16 | Copper | ∼ 2000 Å |
| Layer 18 | Copper | ∼ 18 µm |

| COMPONENT No. 5 | | |
|---|---|---|
| | MATERIAL | THICKNESS |
| Polymer film 12 | Polyimide (Kapton®-E) | 50 µm |
| Tiecoat 14 | Chromium | ∼450 Å |
| Seed layer 16 | Copper | ∼2000 Å |
| Layer 18 | Copper | ∼18 µm |

| COMPONENT No. 6 | | |
|---|---|---|
| | MATERIAL | THICKNESS |
| Polymer film 12 | Polyimide (Apical®-HP) | 50 µm |
| Tiecoat 14 | Chromium | ∼ 150 Å |
| Seed layer 16 | Copper | ∼ 2000 Å |
| Layer 18 | Copper | ∼ 18 µm |

| COMPONENT No. 7 | | |
|---|---|---|
| | MATERIAL | THICKNESS |
| Polymer film 12 | Polyimide (Apical®-HP) | 50 µm |
| Tiecoat 14 | Chromium | ∼465 Å |
| Seed layer 16 | Copper | ∼2000 Å |
| Layer 18 | Copper | ∼18 µm |

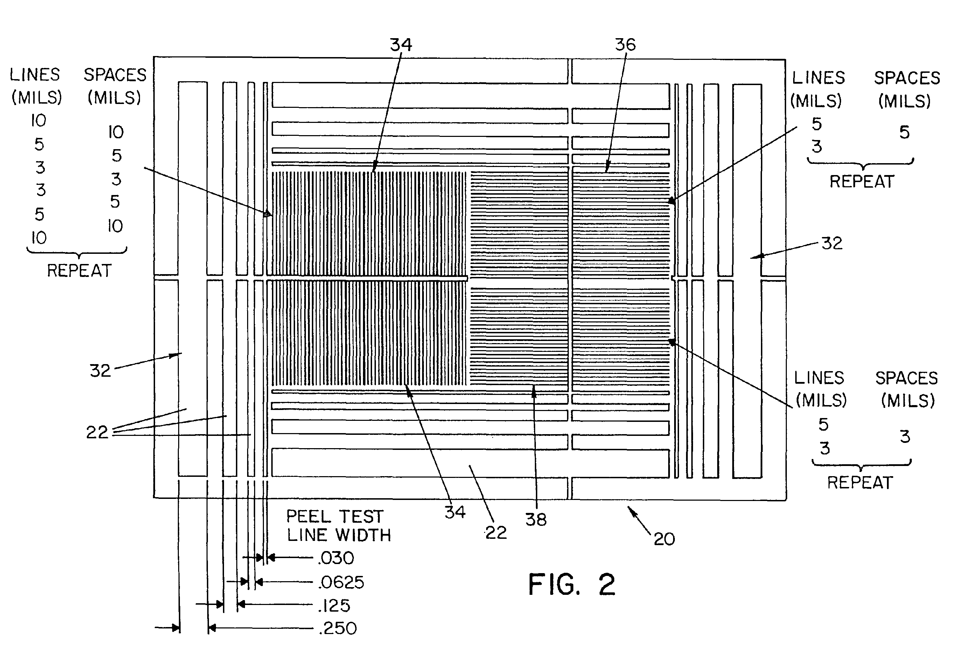

On each of the above-identified components, a test pattern 20 (best seen in FIG. 2) comprised of trace lines 22 of varying widths is formed by conventional circuit forming techniques. Trace lines 22 are arranged in regions 32, 34, 36 and 38. Each region 32, 34, 36 and 38 has trace lines 22 of select width that are arranged with predetermined spacings therebetween, as identified in FIG. 2.

One or more of each of the foregoing components Nos. 1-7, with test pattern 20 formed thereon, is exposed to a gold plating process. The gold plating process includes a number of preliminary etching, cleaning and pre-plating steps prior to immersing the components in an electroless gold plating solution. These preliminary steps, with the exception of two, gold-to-copper adhesion promoting steps, expose the components for relatively short durations, typically 30 seconds or less, to solutions of various pH, composition and temperature. The gold-to-copper adhesion promoting steps expose the components to the various solutions for a total of about 13 minutes. These preliminary steps are of relatively short duration and have relatively mild chemistries as compared to an electroless gold plating solution, and none of the components tested shows any noticeable loss of adhesion between the copper trace lines and polyimide substrate during the preliminary steps.

Following the preliminary etching, cleaning and pre-plating steps, the components are exposed to an electroless gold plating solution. The gold plating solution has a temperature of about 175°F (about 80°C) and has a batch chemistry as follows:

| | |
|---|---|
| about 35 g/l | - KOH |
| about 3-4 g/l | - CN |
| about 4 g/l | - Au |
| about 8 g/1 | - dimethylamine borane (reducing agent) |

The bath was agitated and the components are moved during each test.

The components are tested in the gold plating solution for several periods of time. As will be appreciated, the longer the component is exposed (i.e., immersed) in the gold plating solution the greater the gold build-up on trace lines 22 of pattern 20. Components Nos. 1-5 are exposed to the gold plating solution for periods of about 50 minutes, about 35 minutes and about 30 minutes.

When immersed in the gold plating solutions for 50 minutes, about 63.6 micro inches of gold is built-up on trace lines 22. Pattern 20 is visually inspected for trace lines 22 that lift from the polyimide film. A trace line 22 is considered "lifted" if any lengthwise portion of the trace line 22 separated completely (i.e., from one edge of the trace line to the other edge of the trace line) from the polyimide film. (The longitudinal end of a trace line that exhibits undercutting is not considered as "lifting" unless the undercutting extends lengthwise from the end of the trace line a distance that is greater than the width of the trace line.) TABLE III shows the type of polyimide and the chromium tiecoat thicknesses of the components tested, and shows the maximum trace line width that "lifted" for each of the identified components when immersed in the electroless gold plating solution for about 50 minutes.

**TABLE III**

| **50 Minute Immersion in Electroless Gold Plating Solution** | | | |
|---|---|---|---|
| **TEST SAMPLE** | **POLYIMIDE MATERIAL** | **THICKNESS OF CHROMIUM TIECOAT** | **MAXIMUM TRACES WITH LIFTED LINES** |
| Component No. 1 | Upilex®-SGA | ∼85 Å | No Lifting |
| Component No. 1 | Upilex®-SGA | ∼85 Å | 3 mil |
| Component No. 2 | Upilex®-SGA | ∼340 Å | No Lifting |
| Component No. 2 | Upilex®-SGA | ∼340 Å | No Lifting |
| Component No. 3 | Kapton®-E | ∼160 Å | 10 mil |
| Component No. 3 | Kapton®-E | ∼160 Å | 5 mil |
| Component No. 4 | Kapton®-E | ∼165 Å | 125 mil |
| Component No. 4 | Kapton®-E | ∼165 Å | 125 mil |
| Component No. 5 | Kapton®-E | ∼450 Å | 62.5 mil |
| Component No. 5 | Kapton®-E | ∼450 Å | 10 mil |

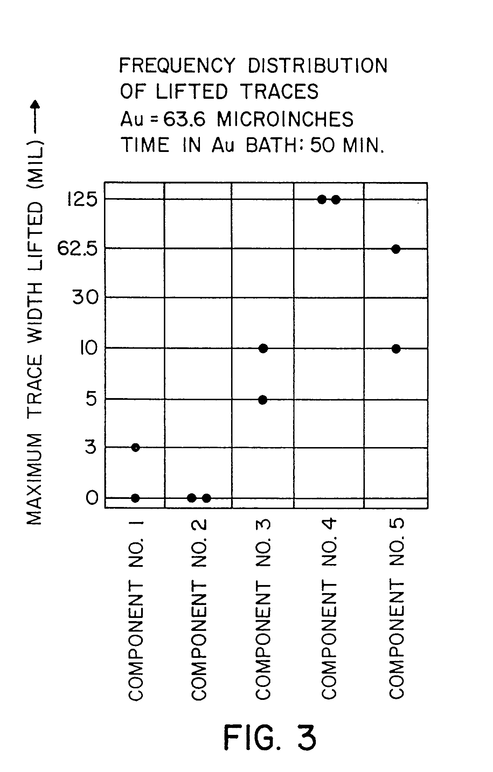

FIG. 3 shows, in graphic form, the data set forth in TABLE III, for each of components Nos. 1-5.

When immersed in the gold plating solutions for about 35 minutes, about 37.4 micro inches of gold is built-up on trace lines 22. TABLE IV shows the type of polyimide and the chromium tiecoat thicknesses of the components tested, and shows the maximum trace line width that "lifted" for each of the identified components when immersed in the electroless gold plating solution for about 35 minutes.

**TABLE IV**

| **35 Minute Immersion in Electroless Gold Plating Solution** | | | |
|---|---|---|---|
| **TEST SAMPLE** | **POLYIMIDE MATERIAL** | **THICKNESS OF CHROMIUM TIECOAT** | **MAXIMUM TRACES WITH LIFTED LINES** |
| Component No. 1 | Upilex®-SGA | ∼85 Å | 3 mil |
| Component No. 2 | Upilex®-SGA | ∼340 Å | No Lifting |
| Component No. 3 | Kapton®-E | ∼160 Å | 10 mil |
| Component No. 3 | Kapton®-E | ∼160 Å | 3 mil |
| Component No. 3 | Kapton®-E | ∼160 Å | No Lifting |
| Component No. 4 | Kapton®-E | ∼165 Å | 62.5 mil |
| Component No.4 | Kapton®-E | ∼165 Å | 62.5 mil |
| Component No. 5 | Kapton®-E | ∼450 Å | 3 mil |

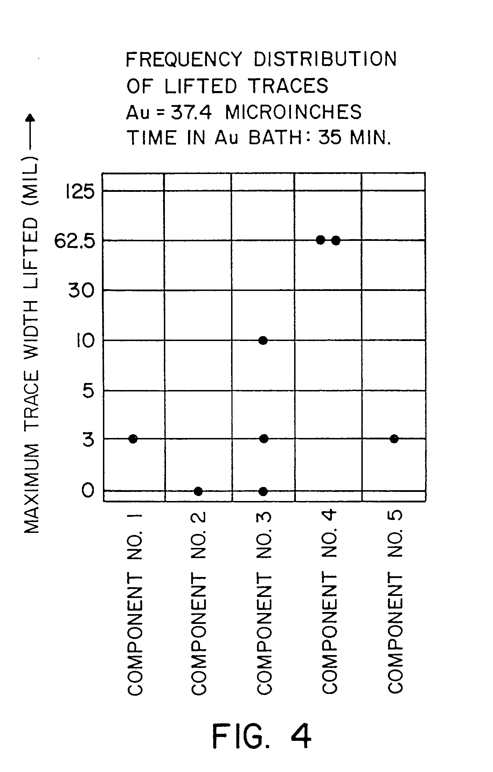

FIG. 4 shows, in graphic form, the data set forth in TABLE IV, for each of components Nos. 1-5.

When immersed in the gold plating solutions for 30 minutes, about 30.3 micro inches of gold is built-up on trace lines 22. TABLE V shows the type of polyimide and the chromium tiecoat thicknesses of the components tested, and shows the maximum trace line width that "lifted" for each of the identified components when immersed in the electroless gold plating solution for about 30 minutes.

**TABLE V**

| **30 Minute Immersion in Electroless Gold Plating Solution** | | | |
|---|---|---|---|
| **TEST SAMPLE** | **POLYIMIDE MATERIAL** | **THICKNESS OF CHROMIUM TIECOAT** | **MAXIMUM TRACES WITH LIFTED LINES** |
| Component No. 1 | Upilex®-SGA | ∼85 Å | No Lifting |
| Component No. 2 | Upilex®-SGA | ∼340 Å | No Lifting |
| Component No. 3 | Kapton®-E | ∼160 Å | No Lifting |
| Component No. 4 | Kapton®-E | ∼165 Å | 10 mil |
| Component No. 4 | Kapton®-E | ∼165 Å | 10 mil |
| Component No. 5 | Kapton®-E | ∼450 Å | No Lifting |
| Component No. 5 | Kapton®-E | ∼450 Å | No Lifting |

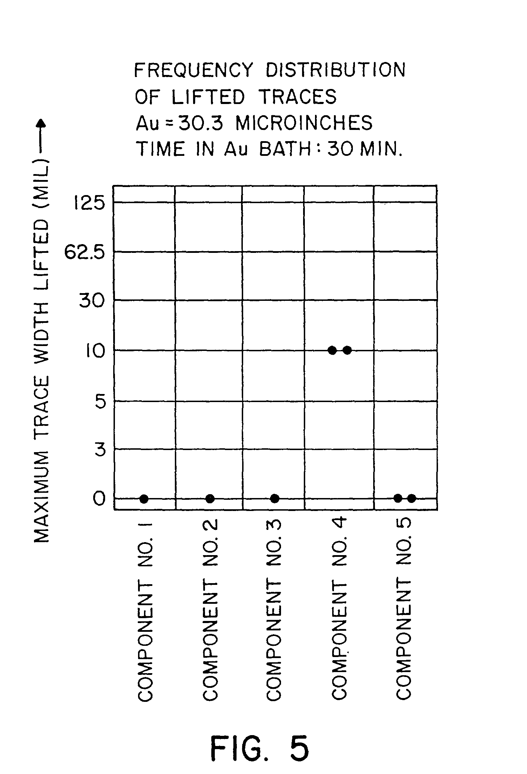

FIG. 5 shows, in graphic form, the data set forth in TABLE V, for each of components Nos. 1-5.

TABLES III-V and FIGS. 3-5 refer to only components Nos. 1-5 because components Nos. 6 and 7 showed relatively poor copper-to-polyimide adhesion even at much shorter immersion periods. For example, when immersed in the gold plating solutions for about 16 minutes, about 16.0 micro inches of gold is built-up on trace lines 22. TABLE VI shows the type of polyimide and the chromium tiecoat thicknesses of the components tested, and shows the maximum trace line width that "lifted" for each of the identified components when immersed in the electroless gold plating solution for about 16 minutes.

**TABLE VI**

| **16 Minute Immersion in Electroless Gold Plating Solution** | | | |
|---|---|---|---|
| **TEST SAMPLE** | **POLYIMIDE MATERIAL** | **THICKNESS OF CHROMIUM TIECOAT** | **MAXIMUM TRACES WITH LIFTED LINES** |
| Component No. 6 | Apical®-HP | ∼150 Å | 62.5 mil |
| Component No. 7 | Apical®-HP | ∼465 Å | 125 mil |
| Component No. 7 | Apical®-HP | ∼465 Å | 125 mil |

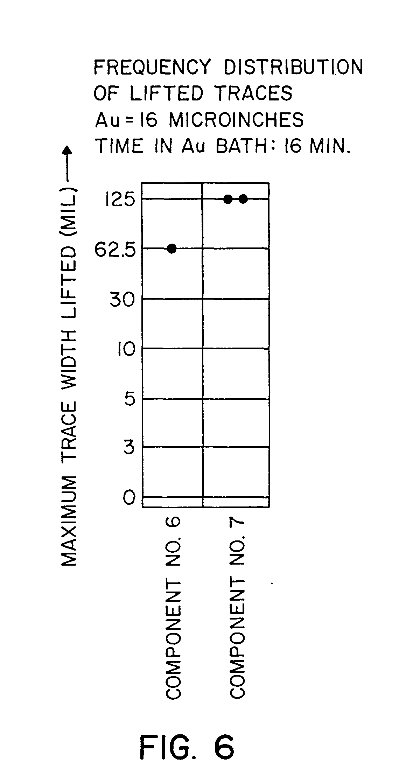

FIG. 6 shows, in graphic form, the data set forth in TABLE VI, the width of the largest trace line 22 that lifted away from the polyimide substrate for components Nos. 6 and 7.

A comparison shows that components formed of Upilex®-SGA polyimide film have the best resistance to adhesion loss after the electroless gold plating. Kapton®-E polyimide film shows less consistency in performance when compared to the Upilex®-SGA polyimide film. Apical®-HP polyimide film showed the most adhesion loss as evidenced by components 6 and 7 as shown in FIG. 6. The Figures also show that a greater chromium thickness improves performance somewhat, particularly on Upilex®-SGA polyimide films.

The charts shown in FIGS. 3-6 identify when complete adhesion loss between a trace line 22 and its polyimide substrate has occurred. It will of course be appreciated that although a trace line 22 did not completely lift from the surface of its respective polyimide film, undercutting of the trace line 22 did occur as a result of immersion in the gold plating bath. FIGS. 7 and 8 schematically illustrate this phenomenon. In FIG. 7, a 3 mil trace line 22 is shown lifted away from its underlying polyimide substrate. It was found the separation of the trace line 22 to the polyimide substrate occurred from penetration from both lateral sides of trace line 22. A trace line 22 ultimately separates from the polyimide substrate when the trace line 22 is exposed to the gold plating solution for sufficient time for the solution to undercut (i.e., penetrate) 1.5 mils. from each lateral edge of trace line 22. As illustrated in FIG. 8, a 5 mil trace line 22 would not lift from the polyimide substrate if exposed to the same gold plating solution for the same period of time. Nevertheless, undercutting from each lateral edge of trace line 22 would cause 1.5 mil along each edge of trace line 22 to separate from the polyimide film. With a 5 mil trace line, 2 mil of copper still adhere to the polyimide substrate thus maintaining the trace line in position on the circuit pattern.

The foregoing description is a specific embodiment of the present invention. It should be appreciated that this embodiment is described for purposes of illustration only, and that numerous alterations and modifications may be practiced by those skilled in the art without departing from the spirit and scope of the invention. It is intended that all such modifications and alterations be included insofar as they come within the scope of the invention as claimed or the equivalents thereof.

## Claims

1. A component for use in manufacturing electronic interconnection devices, comprised of:
a Upilex®-SGA polyimide film having a thickness of between about 12 µm and about 125 µm;
a chromium tiecoat on a surface of said polyimide film, said chromium tiecoat having a thickness of between about 300 Å and about 350 Å; and
a copper layer on said tiecoat, said copper layer having a thickness between about 300 Å and about 70 µm.

2. A component as defined in claim 1, wherein said tiecoat has a thickness greater than 170 Å.

3. A component as defined in claim 2, wherein said polyimide film has thickness between 20 µm and 75 µm.

4. A component as defined in claim 3, wherein said polyimide film has a thickness of about 50 µm.

5. A component as defined in claim 3, wherein said polyimide film has a thickness of about 25 µm.

6. A component as defined in claim 3, wherein said polyimide film has a thickness of about 20 µm.

7. A component as defined in claim 1, wherein said copper layer is vacuum deposited and has a thickness between about 300 Å and about 5,000 Å.

8. A component for use in manufacturing electronic interconnection devices, comprised of:
a polyimide film having a thickness of between about 12 µm and about 125 µm;
a tiecoat on a surface of said polyimide film, said tiecoat having a thickness of between about 250 Å and about 500 Å and being a metal selected from the group consisting of chromium, nickel, palladium, titanium, vanadium, aluminum, iron, chromium-based alloys and nickel-based alloys; and
a copper layer on said tiecoat, said copper layer having a thickness between about 300 Å and about 70 µm.

9. A component as defined in claim 8, wherein said tiecoat is chromium.

10. A component as defined in claim 9, wherein said tiecoat has a thickness between about 300 Å and about 350 Å.

11. A component as defined in claim 10, wherein said polyimide is selected from the group consisting of Upilex®-SGA and Kapton®-E.

12. A component as defined in claim 10, wherein said polyimide is Upilex®-SGA.

13. A component as defined in claim 12, wherein said tiecoat is applied by a vacuum deposition process.

14. A component as defined in claim 12, wherein said copper layer is comprised of a seedcoat layer of copper and a thicker outer layer of copper.

15. A component as defined in claim 14, wherein said outer layer of copper is applied by an electrodeposition process.

16. A component as defined in claim 8, wherein said copper layer is vacuum deposited and has a thickness between about 300 Å and about 5,000 Å.

17. A method of forming a copper-on-polyimide component, comprising the steps of:
a) pre-treating a surface of a polyimide film having a thickness between about 12 µm and about 125 µm;
b) applying by a vacuum deposition process, a first metal as a tiecoat onto said surface of said polyimide film, said first metal selected from the group consisting of chromium, nickel, palladium, titanium, aluminum, iron, chromium-based alloys and nickel-based alloys, said tiecoat having a thickness between 250 Å and 500 Å;
c) applying by a vacuum deposition process, a seedcoat of copper onto said first metal, said seedcoat having a thickness between 300 Å and 5,000 Å; and
d) electroplating copper onto said seedcoat, wherein the copper on said component has a thickness between about 300 Å and about 70 µm.

18. A method as defined in claim 17, wherein said first metal is chromium.

19. A method as defined in claim 18, wherein said chromium has a thickness between about 300 Å and about 350 Å.

20. A method as defined in claim 19, wherein said chromium is sputter-deposited.

21. A method as defined in claim 20, wherein said seedcoat of copper is sputter-deposited.

22. A method as defined in claim 17, wherein said seedcoat of copper has a thickness of about 2,000 Å.

23. A method as defined in claim 17, wherein said polyimide film is Upilex®-SGA.
